# EUROPÄISCHE PATENTANMELDUNG

(11) **EP 4 290 554 A2**
(43) Veröffentlichungstag der Anmeldung: **13.12.2023**
(21) Anmeldenummer: 23206075.6
(22) Anmeldetag: 26.10.2023
(51) Int. Cl.: H01L 21/02, H01L 21/66

(54) **PARAMETRISIERUNG DER RUNDUNG EINER SCHEIBE AUS HALBLEITERMATERIAL**

(71) Anmelder: Siltronic AG, 81677 München (DE)
(72) Erfinder: Haid, Richard, 84547 Emmerting (DE); Hager, Thomas, 84323 Massing (DE); Riedel, Frank, 84529 Tittmoning (DE); Zierer, Robert, 09599 Freiberg (DE)
(74) Vertreter: Grundner, Sebastian

(57) **Zusammenfassung**

Verfahren zur Bestimmung der Rundung einer Scheibe aus Halbleitermaterial, umfassend die folgenden Schritte in dieser Reihenfolge:
(i) Messen des Höhenprofils einer Scheibe aus Halbleitermaterial in radialer Richtung in deren Randbereich und in einem in Radialinwärtsrichtung an den Randbereich angrenzenden Bereich, wobei der Randbereich definiert ist, als ringförmiger Bereich am äußeren Rand der Scheibe, in dem sich die Dicke der Scheibe in Radialauswärtsrichtung kontinuierlich verringert;
(ii) Festlegen eines radialen Abschnittes, der einen Teil des Randbereiches und zumindest einen Teil des in Radialinwärtsrichtung an den Randbereich angrenzenden Bereiches der Scheibe aus Halbleitermaterial umfasst;
(iii) Bestimmung eines Winkels ϕ und optional eines Winkels θ für bestimmte Messpunkte P1 des Höhenprofils im radialen Abschnitt,
wobei der Winkel ϕ aus dem jeweiligen bestimmten Messpunkt P1 als Scheitelpunkt, und zwei weiteren Messpunkten P2 und P3 des Höhenprofils gebildet wird, die in einem bestimmten radialen Abstand a vom Scheitelpunkt in Radialinwärtsrichtung und in Radialauswärtsrichtung angeordnet sind, und
wobei der Winkel θ aus der Differenz 180°-ϕ erhalten wird; und

(iv) Identifizieren des kleinsten Winkels ϕ oder optional des größten Winkles θ im radialen Abschnitt als Kennzahl für die Rundung.

## Beschreibung

### Technisches Gebiet

Gegenstand der vorliegenden Erfindung sind Verfahren zur Bestimmung der Rundung einer Scheibe aus Halbleitermaterial.

### Stand der Technik

Scheiben aus Halbleitermaterial werden in einer Vielzahl von Prozessschritten hergestellt, die das Ziehen eines Einkristallstabs aus einer Schmelze, das Zersägen des Kristalls in Scheiben, das Schleifen, das Kantenverrunden, das Polieren und das chemische Reinigen der Scheiben umfassen.

Das Kantenverrunden erfolgt dabei üblicherweise mithilfe einer Kantenverrundungsschleifscheibe, die an ihrem Rand über umlaufende Rillen mit einem bestimmten Profil verfügt. Die Rillenform entspricht dabei dem Negativ des gewünschten Kantenprofils. Der Rand der rotierenden Schleifscheibe wird dabei in Kontakt mit dem Rand der rotierenden Scheibe aus Halbleitermaterial gebracht, so dass das gewünschte Kantenprofil in den Rand der Scheibe aus Halbleitermaterial geschliffen wird.

Neben dem eigentlichen Kantenprofil, also der Form des ringförmigen Randbereiches der Scheibe, in dem sich die Dicke der Scheibe aus Halbleitermaterial in Radialauswärtsrichtung kontinuierlich verringert oder verjüngt, rückt die Geometrie der Scheibe am Übergang zwischen dem Randbereich und der Hauptfläche zunehmend in den Vordergrund. So hängt die Ausbeute einer Produktionslinie zur Herstellung von integrierten Schaltungen unter anderem von der Form des Übergangs zwischen der Hauptfläche und dem sich verjüngenden Randbereich der Scheibe ab. Somit ist es erforderlich, diesen Übergang zur messen und zu parametrisieren, um das Profil der Scheibe am Übergang vom Randbereich zur Hauptfläche spezifizieren und optimieren zu können.

US 2020/0090923 A1 ist auf ein Verfahren zum Polieren des Randbereichs einer Scheibe aus Halbleitermaterial gerichtet, welches die Bestimmung des Winkels am Übergang vom Randbereich zur Hauptfläche umfasst. Die dort beschriebene Methode zur Bestimmung des Winkels am Übergang setzt voraus, dass die Dicke im Randbereichs linear abnimmt und nur am äußersten Rand durch eine Rundung beschrieben wird. US 2020/0240929 A1 beschreibt eine Methode zur Evaluierung des Übergangs zwischen der Kante und der Hauptfläche, bei der als Kenngröße für die Rundung ein Winkel und ein Radius entlang eines Querschnittes einer Scheibe bestimmt werden. US 11,656,186 B2 beschreibt ebenfalls ein Verfahren zur Analyse der Kante und des Übergangsbereiches zur Hauptfläche. In all diesen Verfahren werden nur wenige Punkte des sich verjüngenden Randbereich in radialer Richtung berücksichtigt. Dadurch ist die mit dem Verfahren ermittelte Kennzahl nur begrenzt aussagekräftig, weil die erhaltene Kenngröße stark von der Auswahl der Messpunkte abhängt. Dadurch wird nicht notwendigerweise der tatsächliche kleinste Winkel/Radius beziehungsweise die tatsächliche maximale Kantigkeit im Übergangsbereich zwischen Hauptfläche und Randbereich ermittelt. Die tatsächliche Geometrie der Scheibe am Übergang zwischen Randbereich und Hauptfläche kann somit nicht mit ausreichender Zuverlässigkeit charakterisiert und parametrisiert werden.

### Technische Aufgabe der Erfindung und deren Lösung

Somit besteht ein Bedarf für ein Verfahren zur genaueren und verlässlicheren Bestimmung der Rundung am Übergang zwischen der Hauptfläche und dem Randbereich einer Scheibe aus Halbleitermaterial.

Die vorliegende Erfindung löst das oben genannte Problem durch die Bereitstellung von Verfahren zur Bestimmung der Rundung am Übergang zwischen der Hauptfläche und dem Randbereich einer Scheibe aus Halbleitermaterial. Die Rundung im Sinne der vorliegenden Erfindung bezieht sich dabei auf den Übergang zwischen der Hauptfläche und dem Randbereich einer Scheibe aus Halbleitermaterial. Der Randbereich ist dabei definiert als ringförmiger Bereich am äußeren Rand der Scheibe, in dem sich die Dicke der Scheibe in Radialauswärtsrichtung kontinuierlich verringert. Dieser Bereich wird auch als Facette und die radiale Ausdehnung dieses Bereichs als Facettenlänge bezeichnet. Der in Radialinwärtsrichtung angrenzenden Teil der Oberfläche der Scheibe wird dabei als Hauptfläche bezeichnet.

Diese Verfahren knüpfen dabei an bekannte Messmethoden zur Bestimmung des Kantenprofils an, die im Rahmen der Prozesskontrolle in der industriellen Fertigung von Scheiben aus Halbleitermaterial eingesetzt werden. Somit kann der Mehraufwand für die Bestimmung der Rundung am Übergang zwischen der Hauptfläche und dem Randbereich minimiert werden, da keine neuen Messgeräte und keine zusätzlichen Messungen für die Bestimmung der Rundung erforderlich sind. Dadurch kann das erfindungsgemäße Verfahren zur Bestimmung der Rundung einfach in die industrielle Fertigung integriert und im Rahmen der Prozesskontrolle durchgeführt werden. Außerdem werden durch das erfindungsgemäße Verfahren neue Kennzahlen zur Bestimmung der Rundung eingeführt, so dass die Rundung leicht und mit hoher Zuverlässigkeit parametrisiert und spezifiziert werden kann. Das erfindungsgemäße Verfahren ist zudem so ausgestaltet, dass eine Vielzahl an Datenpunkte in die Bestimmung der Kennzahl einfließen. Dadurch kann für unterschiedliche Kantenprofilen eine aussagekräftige Kennzahl für die Rundung mit hoher Genauigkeit ermittelt werden. Eine Kennzahl im Sinne der vorliegenden Erfindung ist eine Zahl zur Quantifizierung des Übergangs zwischen dem Randbereich und der Hauptfläche einer Scheibe aus Halbleitermaterial. Insbesondere Winkel oder Radien eignen sich zur Quantifizierung von solchen Oberflächenverläufen.

Das Verfahren zur Bestimmung der Rundung einer Scheibe aus Halbleitermaterial gemäß dem ersten Aspekt der vorliegenden Erfindung umfasst die folgenden Schritte:
(i) Messen des Höhenprofils einer Scheibe aus Halbleitermaterial in radialer Richtung in deren Randbereich und in einem in Radialinwärtsrichtung an den Randbereich angrenzenden Bereich, wobei der Randbereich definiert ist, als ringförmiger Bereich am äußeren Rand der Scheibe, in dem sich die Dicke der Scheibe in Radialauswärtsrichtung kontinuierlich verringert;
(ii) Festlegen eines radialen Abschnittes, der einen Teil des Randbereiches und zumindest einen Teil des in Radialinwärtsrichtung an den Randbereich angrenzenden Bereiches der Scheibe aus Halbleitermaterial umfasst;
(iii) Bestimmung eines Winkels ϕ und optional eines Winkels θ für bestimmte Messpunkte P1 des Höhenprofils im radialen Abschnitt,
   wobei der Winkel ϕ aus dem jeweiligen bestimmten Messpunkt P1 als Scheitelpunkt, und zwei weiteren Messpunkten P2 und P3 des Höhenprofils gebildet wird, die in einem bestimmten radialen Abstand a vom Scheitelpunkt in Radialinwärtsrichtung und in Radialauswärtsrichtung angeordnet sind, und
   wobei der Winkel θ aus der Differenz 180°ϕ erhalten wird; und
(iv) Identifizieren des kleinsten Winkels ϕ oder optional des größten Winkles θ im radialen Abschnitt als Kennzahl für die Rundung.

Das Verfahren zur Bestimmung der Rundung einer Scheibe aus Halbleitermaterial gemäß dem zweiten Aspekt der vorliegenden Erfindung umfasst die folgenden Schritte:
(i) Messen des Höhenprofils einer Scheibe aus Halbleitermaterial in radialer Richtung in deren Randbereich und in einem in Radialinwärtsrichtung an den Randbereich angrenzenden Bereich, wobei der Randbereich definiert ist, als ringförmiger Bereich am äußeren Rand der Scheibe, in dem sich die Dicke der Scheibe in Radialauswärtsrichtung kontinuierlich verringert;
(ii) Festlegen eines radialen Abschnittes, der einen Teil des Randbereiches und zumindest einen Teil des in Radialinwärtsrichtung angrenzenden Bereiches der Scheibe aus Halbleitermaterial umfasst;
(iii) Zuordnen eines Radius r zu bestimmten Messpunkten P1 des Höhenprofils im radialen Abschnitt, wobei der Radius r dem Radius eines Kreises entspricht, auf dessen Kreislinie der jeweilige bestimmte Messpunkt P1 und zwei weitere Messpunkte P2 und P3 des Höhenprofils liegen, die in einem bestimmten radialen Abstand a vom jeweiligen bestimmten Messpunkt in Radialinwärtsrichtung und in Radialauswärtsrichtung angeordnet sind; und
(iv) Identifizieren des kleinsten Radius r im radialen Abschnitt als Kennzahl für die Rundung.

### Kurzbeschreibung der Figuren

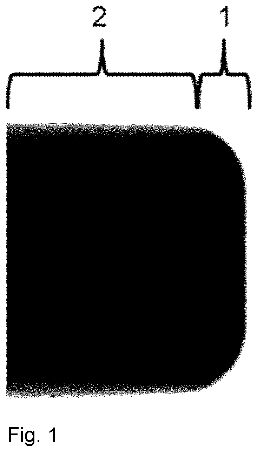

**Fig. 1** zeigt das mithilfe eines Lichtschnittverfahrens gemessene Profil des Randbereiches (1) und des in Radialinwärtsrichtung an den Randbereich angrenzenden Bereiches (2) einer Scheibe aus einkristallinem Silizium mit einem Durchmesser von 300 mm.

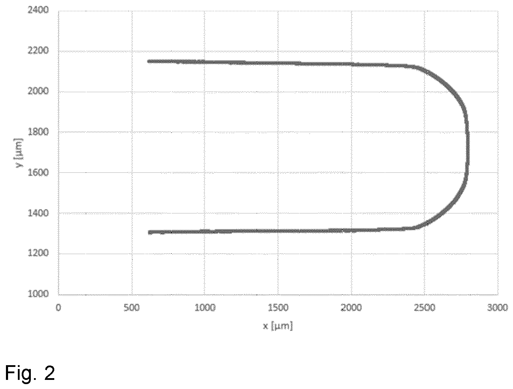

**Fig. 2** zeigt das als x-y-Kurve dargestellte Höhenprofil einer Scheibe aus einkristallinem Silizium mit einem Durchmesser von 300 mm in deren Randbereich und in einem in Radialinwärtsrichtung an den Randbereich angrenzenden Bereich, wobei die x-Achse die radiale Position und die y-Achse die axiale Position angibt.

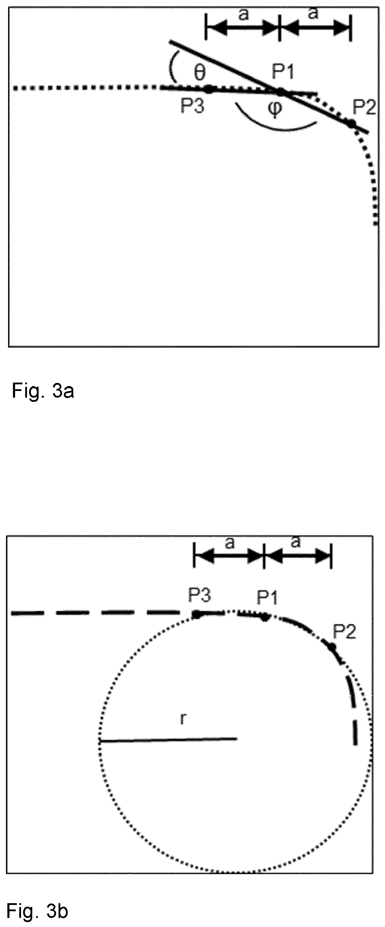

**Fig. 3a** zeigt schematisch den Schritt (iii) des Verfahrens gemäß dem ersten Aspekt der vorliegenden Erfindung, in dem einem bestimmten Messpunkt P1 des Höhenprofils ein Winkel ϕ zugeordnet wird, wobei der Winkel ϕ aus dem jeweiligen bestimmten Messpunkt P1 als Scheitelpunkt, und zwei weiteren Messpunkten P2 und P3 des Höhenprofils gebildet wird, die in einem bestimmten radialen Abstand a vom Scheitelpunkt P1 in Radialinwärtsrichtung beziehungsweise in Radialauswärtsrichtung angeordnet sind. Der Winkel θ ergibt sich aus der Different von 180°-ϕ.
**Fig. 3b** zeigt schematisch den Schritt (iii) des Verfahrens gemäß dem zweiten Aspekt der vorliegenden Erfindung, in dem einem bestimmten Messpunkt P1 des Höhenprofils ein Radius r zugeordnet wird, wobei der Radius dem Radius eines Kreises entspricht, auf dessen Kreislinie der Punkt P1 und zwei weitere Messpunkte P2 und P3 liegen, die in einem bestimmten radialen Abstand a von P1 in Radialinwärtsrichtung beziehungsweise in Radialauswärtsrichtung angeordnet sind.

### Detaillierte Beschreibung der Erfindung

Im erfindungsgemäßen Verfahren zur Bestimmung der Rundung einer Scheibe aus Halbleitermaterial gemäß dem ersten Aspekt der vorliegenden Erfindung erfolgt zunächst die Messung des Höhenprofils einer Scheibe aus Halbleitermaterial in radialer Richtung in deren Randbereich und in einem in Radialinwärtsrichtung an den Randbereich angrenzenden Bereich.

Der Randbereich ist definiert ist als ringförmiger Bereich am äußeren Rand der Scheibe, in dem sich die Dicke der Scheibe in Radialauswärtsrichtung kontinuierlich verringert oder verjüngt. Der Randbereich hat dabei vorzugsweise eine radiale Ausdehnung von nicht weniger als 50 µm und nicht mehr als 500 µm, vorzugsweise nicht weniger als 100 µm und nicht mehr als 400 µm. Der in Radialinwärtsrichtung an den Randbereich angrenzende Bereich der Scheibe, dessen Höhenprofil gemessen wird, hat vorzugsweise eine radiale Ausdehnung von nicht weniger als 50 µm, vorzugsweise nicht weniger als 100 µm und nicht mehr als 3000 µm.

Das Höhenprofil im Sinne der vorliegenden Erfindung beschreibt den Verlauf der axialen Ausdehnung einer Scheibe aus Halbleitermaterial in Abhängigkeit von der radialen Position. Das Höhenprofil kann dabei das Höhenprofil der Vorderseite oder das Höhenprofil der Rückseite der Scheibe aus Halbleitermaterial sein. Vorzugsweise ist das Höhenprofil das Höhenprofil der Vorderseite der Scheibe aus Halbleitermaterial. Die axiale Ausdehnung der Scheibe aus Halbleitermaterial wird dabei vorzugsweise durch den axialen Abstand der Oberfläche der Vorderseite oder der Rückseite der Scheibe, besonders bevorzugt der Vorderseite, von der Mittellinie der Scheibe bestimmt. Die radiale Position ist dabei der radiale Abstand von der Drehachse der Scheibe aus Halbleitermaterial oder der radiale Abstand vom Scheibenrand. Es kann auch ein beliebiger radialer Abstand vom Scheibenmittelpunkt oder vom Scheibenrand als Nullpunkt für die Quantifizierung des radialen Abstand gesetzt werden. Jeder Messpunkt an der Oberfläche der Scheibe aus Halbleitermaterial ist also durch seine radiale Position (x) und seine axiale Ausdehnung (y) bestimmt, so dass das Höhenprofil als x-y-Kurve dargestellt werden kann. Dieser Datensatz kann als csv-Datei ausgegeben und diese anschließend mithilfe eines vorher festgelegten Computer-Programmes bearbeitet und ausgewertet werden. Durch Ausgleichsrechnung, beispielsweise Fitting oder Regression, können ausgehend von dem x-y-Datensatz Parameter, die die Kantenform beschreiben, ermittelt werden. Solche Parameter sind beispielsweise (i) die Facettenlänge, die die radiale Ausdehnung des sich kontinuierlich verjüngenden Randbereichs quantifiziert, (ii) der Schulterradius, der die Krümmung im äußersten Randbereich beschreibt, und (iii) die Apexlänge, die die axiale Ausdehnung des senkrecht zur Hauptfläche verlaufenden Seitenfläche beschreibt.

Das Höhenprofil kann dabei mittels Reflektionsmessung durch Beleuchtung der Scheibe aus Halbleitermaterial mit einem Laser als Lichtquelle und Detektion des reflektierten Lichtes mittels eines Detektors, beispielsweise einer Photodiode, erfolgen. Das Höhenprofil kann auch über ein Lichtschnittverfahren ermittelt werden. Das Lichtschnittverfahren ist ein Verfahren der optischen Messtechnik, welches die Vermessung eines Höhenprofils entlang einer projizierten Lichtlinie ermöglicht. Dabei wird, vorzugsweise mit einem Laser oder einer LED als Lichtquelle, eine Schattenprojektion des Messobjektes erzeugt, die mittels einer elektronischen Kamera oder eines CCD-Sensors detektiert wird. Die Scheibe wird dabei vorzugsweise so beleuchtet, dass eine Schattenprojektion des Querschnitts detektiert werden kann. Vorzugsweise wird die Lichtquelle relativ zur Scheibe so positioniert, dass das Licht der Lichtquelle senkrecht zur Achse der Scheibe auf die Scheibe trifft. Vorzugsweise erfolgt die Messung des Höhenprofils mit dem Lichtschnittverfahren. Der Grund hierfür ist, dass das Lichtschnittverfahren auch für die Messung von polierten Scheiben aus Halbleitermaterial verwendbar ist. Die Schattenprojektion gibt das Höhenprofil einer Scheibe aus Halbleitermaterial mit einer Genauigkeit von ±0.1 µm wieder.

Vorzugsweise werden bei der Messung des Höhenprofils der Scheibe aus Halbleitermaterial nicht weniger als 10 Messpunkte, besonders bevorzugt nicht weniger als 20 Messpunkte, mehr bevorzugt nicht weniger als 100 Messpunkte, und am meisten bevorzugt nicht weniger als 1000 Messpunkte mit unterschiedlicher radialer Position aufgenommen. Die Dichte der Messpunkte liegt dabei vorzugsweise im Bereich von nicht weniger als 2 Messpunkten, mehr bevorzugt nicht weniger 5 Messpunkten, besonders bevorzugt nicht weniger als 10 Messpunkten, jeweils in einem Abschnitt mit einer radialen Ausdehnung von 1 µm. Die Dichte der Messpunkte ist vorzugsweise nicht mehr als 100 Messpunkte in einem Abschnitt mit einer radialen Ausdehnung von 1 µm. Die Messung kann auch mehrere Einzelmessungen umfassen, wobei die Halbleiterscheibe zwischen den Messungen um ihre Rotationsachse um einen Winkel α gedreht wird. Die Messung kann dabei aus x Einzelmessungen bestehen, zwischen denen die Scheibe aus Halbleitermaterial im Messgerät um den Winkel α gedreht wird, wobei x und α vorzugsweise so gewählt werden, dass das Produkt aus x (Anzahl der Einzelmessungen) und α (Drehwinkle in °) 360° ergibt. Dies ermöglicht es, einen für den gesamten Umfang der Scheibe repräsentative Messung zu erhalten. Vorzugsweise ist x=4 und α=90°, besonders bevorzugt x=8 und α =45°, am meisten bevorzugt ist x=32 und α=11,25°.

Ausgehend von dem gemessenen Höhenprofil wird ein radialer Abschnitt festgelegt, der einen Teil des Randbereiches und zumindest einen Teil des in Radialinwärtsrichtung angrenzenden Bereiches der Scheibe aus Halbleitermaterial umfasst. Der Teil des Randbereiches, der vom radialen Abschnitt umfasst wird, hat vorzugsweise eine radiale Ausdehnung von nicht mehr als 30%, besonders bevorzugt nicht mehr als 20%, der radialen Ausdehnung des gesamten Randbereiches. Durch diese Begrenzung wird sichergestellt, dass der stark gekrümmte Bereich des Kantenprofils in den erfindungsgemäßen Verfahren nicht berücksichtigt wird und sich die ermittelte Kennzahl tatsächlich auf den Übergang von Randbereich zur Hauptfläche bezieht, und nicht etwaige kleinere Winkel ϕ, größere Winkel θ, oder größere Radien r des Kantenprofils im weiter radial auswärtsgelegenen Teil die Kennzahl für die Rundung am Übergang zur Hauptfläche verfälschen. Durch eine Begrenzung des für den radialen Abschnitt ausgewählten Teils des Randbereiches im Schritt (ii) auf nicht mehr als 20% der radialen Ausdehnung des gesamten Randbereiches ist dies für eine Vielzahl von Kantenprofilen sichergestellt.

Der Teil des Randbereiches, der vom radialen Abschnitt umfasst wird, ist dabei der radialinwärtsliegende Teil des Randbereiches. Dadurch, dass der festgelegte radiale Abschnitt einen Großteil des Randbereichs und insbesondere des äußeren Teils des Randbereiches ausschließt, kann sichergestellt werden, dass die starke Krümmung des Kantenprofils nicht in die weitere Auswertung einfließt und der ausgehend von dem festgelegten radialen Abschnitt ermittelte Wert für die Rundung sich tatsächlich auf den Übergangsbereich zwischen Rand und Hauptfläche bezieht.

Vorzugsweise hat der ausgewählte radiale Abschnitt eine radiale Ausdehnung von nicht weniger als 200 µm, vorzugsweise nicht weniger als 500 µm, am meisten bevorzugt nicht weniger als 1000 µm und nicht mehr als 1500 µm. Der radiale Abschnitt wird dabei vorzugsweise so ausgewählt, dass der vom radialen Abschnitt umfasste Teil des Randbereiches nicht weniger als 50 µm und nicht mehr als 200 µm beträgt.

Gemäß dem ersten Aspekt der vorliegenden Erfindung wird, nachdem der radiale Abschnitt festgelegt wurde, bestimmten Messpunkt des Höhenprofils im radialen Abschnitt ein Winkel zugeordnet. Dafür werden bestimmte Messpunkte des Höhenprofils im radialen Abschnitt ausgewählt, denen eine Winkel zugeordnet werden soll. Dabei kann entweder jedem Messpunkt des Höhenprofils im radialen Abschnitt ein Winkel zugeordnet werden oder es kann nur einem Teil der Messpunkte des Höhenprofils im radialen Abschnitt ein Winkel zugeordnet werden. Die Messpunkte, denen ein Winkel zugeordnet wird, werden dabei als bestimmte Messpunkte bezeichnet. Vorzugsweise wird mindestens 10 bestimmten Messpunkte, besonders bevorzugt mindestens 20 Messpunkten und am meisten bevorzugt mindestens 50 Messpunkten, ein Winkel zugeordnet. Vorzugsweise liegen jeweils nicht weniger als 5 Messpunkte, denen ein Winkel zugeordnet wird im vom radialen Abschnitt umfasste Teil des Randbereiches und im daran in Radialinwärtsrichtung angrenzenden Bereich.

Die bestimmten Messpunkte des Höhenprofils im radialen Abschnitt, denen ein Winkel zugeordnet wird, können beispielsweise alle Messpunkte im radialen Abschnitt sein oder Messpunkte, die in einem festgelegten radialen Abstand entlang des Höhenprofils angeordnet sind. Der *"festgelegte radiale Abstand"* beschreibt also den Abstand der bestimmten Messpunkte, denen ein Winkel zugeordnet wird, voneinander. Der festgelegte radiale Abstand der Messpunkte, denen ein Winkel zugeordnet wird, beträgt vorzugsweise nicht weniger als 10 µm und nicht mehr als 200 µm, mehr bevorzugt nicht weniger als 20 µm und nicht mehr als 100 µm.

Den bestimmten Messpunkten wird dabei ein Winkel ϕ und/oder ein Winkel θ zugeordnet. Der Winkel ϕ wird aus dem jeweiligen bestimmten Messpunkt P1 als Scheitelpunkt und zwei weiteren Messpunkten P2 und P3 des Höhenprofils gebildet, die in einem bestimmten radialen Abstand a vom Scheitelpunkt P1 in Radialinwärtsrichtung (P3) beziehungsweise in Radialauswärtsrichtung (P2) angeordnet sind. Dies ist schematisch in Fig. 3a dargestellt. Die beiden Schenkel des Winkels sind jeweils durch den Scheitelpunkt P1 und einem der beiden weiteren Messpunkte P2 und P3 definiert. Der Ausdruck *"bestimmter radialer Abstand"* bezieht sich also auf die radialen Abstände a eines Messpunktes, der als Scheitelpunkt herangezogen wird zu zwei weiteren Messpunkten, aus denen der Winkel gebildet wird. Der bestimmte radiale Abstand a beträgt vorzugsweise nicht weniger als 10 µm und nicht mehr al 100 µm, mehr bevorzugt nicht weniger als 20 µm und nicht mehr als 80 µm, besonders bevorzugt nicht weniger als 30 µm und nicht mehr als 60 µm. Der Winkel ϕ bezieht sich dabei stets auf den kleinsten Winkel, der von den drei Messpunkten gebildet wird, so dass der Winkel nie einen Wert von mehr als 180° hat. Der Winkel θ kann ausgehend vom Winkel ϕ aus der Differenz 180°-ϕ erhalten werden.

In einer Ausführungsform wird der Winkel aus einem bestimmten Messpunkt als Scheitelpunkt und den beiden benachbarten bestimmten Messpunkten in Radialinwärtsrichtung beziehungsweise in Radialauswärtsrichtung gebildet. In diesem Fall sind der festgelegte radiale Abstand und der bestimmte radiale Abstand identisch.

Da bei Höhenmessungen üblicherweise die Dichte der Messpunkte in Radialinwärtsrichtung abnimmt, kann sowohl (i) der festgelegte radiale Abstand der bestimmten Messpunkte zueinander als auch (ii) der bestimmte radiale Abstand eines Scheitelpunktes zu den beiden weiteren Punkten, die die Schenkel de Winkles definieren, im radialen Abschnitt variieren. Vorzugsweise variiert der bestimmte radiale Abstand im radialen Abschnitt um nicht mehr als 10 µm, besonders bevorzugt nicht mehr als 6 µm, am meisten bevorzugt nicht mehr als 2 µm. Demensprechend ist der bestimmte radiale Abstand mit einer Genauigkeit von ± 5 µm, vorzugsweise ± 3 µm, besonders bevorzugt ± 1 µm behaftet. Vorzugsweise variiert der festgelegte radiale Abstand im radialen Abschnitt um nicht mehr als 10 µm, besonders bevorzugt nicht mehr als 6 µm, am meisten bevorzugt nicht mehr als 2 µm. Demensprechend ist der festgelegte radiale Abstand mit einer Genauigkeit von ± 5 µm, vorzugsweise ± 3 µm, besonders bevorzugt ± 1 µm behaftet.

Nachdem jedem bestimmten Messpunkt des Höhenprofils im radialen Abschnitt ein Winkel ϕ oder θ zugeordnet worden ist, wird der kleinste Winkel ϕ oder der größte Winkel θ im radialen Abschnitt identifiziert. Anschließend kann der kleinste Winkel ϕ oder der größte Winkel θ als Kennzahl für die Rundung herangezogen werden. Die Winkel ϕ und θ eignen sich gleichermaßen als Kennzahl, solange der jeweilige Winkel für jeden bestimmten Messpunkt bestimmt wurde.

Das Verfahren gemäß dem zweiten Aspekt der vorliegenden Erfindung unterscheidet sich vom Verfahren gemäß dem ersten Aspekt der vorliegenden Erfindung dadurch, dass anstatt der Zuordnung eines Winkels die Zuordnung eines Radius r zu bestimmten Messpunkten des Höhenprofils im radialen Abschnitt erfolgt. Dies ist schematisch in Fig. 3b dargestellt. Dafür werden bestimmte Messpunkte P1 des Höhenprofils im radialen Abschnitt ausgewählt, denen eine Radius zugeordnet werden soll. Die Messpunkte, denen ein Radius r zugeordnet wird, werden dabei als bestimmte Messpunkte P1 bezeichnet. Dabei entspricht der Radius r dem Radius eines Kreises, auf dessen Kreislinie der jeweilige bestimmte Messpunkt P1 und zwei weitere Messpunkte P2 und P3 des Höhenprofils liegen, die in einem bestimmten radialen Abstand a vom jeweiligen bestimmten Messpunkt P1 in Radialinwärtsrichtung (P3) beziehungsweise in Radialauswärtsrichtung (P2) angeordnet sind.

Die bestimmten Messpunkte des Höhenprofils im radialen Abschnitt, denen ein Radius zugeordnet wird, können beispielsweise Messpunkte sein, die in einem festgelegten radialen Abstand entlang des Höhenprofils angeordnet sind. Der *"festgelegte radiale Abstand"* beschreibt also den Abstand der bestimmten Messpunkte, denen ein Radius zugeordnet wird, voneinander. Der festgelegte radiale Abstand der Messpunkte, denen ein Radius zugeordnet wird, beträgt vorzugsweise nicht mehr als 100 µm, mehr bevorzugt nicht mehr als 50 µm, noch mehr bevorzugt nicht mehr als 25 µm. Wenn der festgelegte radiale Abstand in diesem Bereich liegt, ist die ermittelte Kennzahl für die Rundung aussagekräftig und signifikant. Wenn der festgelegte radiale Abstand 25 µm nicht überschreitet, insbesondere wenn der festgelegte radiale Abstand 10 µm nicht überschreitet, kann die Aussagekraft und Genauigkeit der ermittelten Kennzahl für die Rundung weiter erhöht werden. Der festgelegte radiale Abstand der Messpunkte, denen ein Radius zugeordnet wird, beträgt vorzugsweise nicht weniger als 20 nm, mehr bevorzugt nicht weniger als 50 nm. Grundsätzlich hängt die Untergrenze des festgelegten radiale Abstandes von der Messpunktdichte ab. Wenn der festgelegte radiale Abstand nicht weniger als 20 nm, mehr bevorzugt nicht weniger als 50 nm beträgt, reicht die Messpunktdichte, die im Rahmen der Prozesskontrolle zur Bestimmung der Kantengeometrie erreicht wird aus, um die erfindungsgemäßen Verfahren durchführen zu können. Somit können die erfindungsgemäßen Verfahren gemäß dem ersten und zweiten Aspekt leicht in die Prozesskontrolle integriert werden, ohne dass zusätzliche Messungen erforderlich sind. In einer weiteren Ausführungsform beträgt der festgelegte radiale Abstand deshalb vorzugsweis nicht weniger als 50 nm und nicht mehr als 10 µm.

Der Ausdruck *"bestimmter radialer Abstand"* bezieht sich auf die radialen Abstände a eines bestimmten Messpunktes zu den zwei weiteren Messpunkten, die zur Bestimmung des Radius herangezogen werden. Der bestimmte radiale Abstand a beträgt vorzugsweise nicht weniger als 10 µm und nicht mehr al 100 µm, mehr bevorzugt nicht weniger als 20 µm und nicht mehr als 80 µm, besonders bevorzugt nicht weniger als 30 µm und nicht mehr als 60 µm.

Vorzugsweise wird allen Messpunkten im radialen Abschnitt ein Radius zugeordnet, so dass jeder Messpunkt des Höhenprofils ein bestimmter Messpunkt ist. Es kann aber auch nur einem Teil der Messpunkte ein Radius zugeordnet werden. Vorzugsweise liegen mindestens 10 bestimmte Messpunkte, besonders bevorzugt mindestens 20 bestimmte Messpunkte und am meisten bevorzugt mindestens 50 bestimmte Messpunkte vor, denen ein Radius zugeordnet ist. Vorzugsweise liegen jeweils nicht weniger als 5 bestimmte Messpunkte im vom radialen Abschnitt umfasste Teil des Randbereiches und im daran in Radialinwärtsrichtung angrenzenden Bereich. Anschließend wird der kleinste Radius im radialen Abschnitt identifiziert. Der kleinste Radius kann dann als Kennzahl für die Rundung herangezogen.

Die erfindungsgemäßen Verfahren gemäß dem ersten oder dem zweiten Aspekt der vorliegenden Erfindung können automatisiert durchgeführt werden. Unter Automatisierung versteht man nach DIN V 19233 das Ausrüsten einer Vorrichtung, so dass sie ganz oder teilweise ohne Mitwirkung eines Menschen bestimmungsgemäß arbeitet, abgesehen von der vorherigen Planung, Konstruktion und Programmierung durch einen Menschen. Dementsprechend ist ein automatisiertes Verfahren im Sinne der vorliegenden Erfindung ein Verfahren, das ganz oder teilweise ohne Mitwirkung eines Menschen bestimmungsgemäß abläuft. Die Schritte (ii) bis (iv) des erfindungsgemäßen Verfahrens gemäß dem ersten oder dem zweiten Aspekt der vorliegenden Erfindung können mithilfe eines vorher festgelegten Computer-Programmes auf einem Rechner durchgeführt werden, wobei das Computer-Programm beispielsweise auf einem Skript der Software Python oder Java basiert. Somit können die Schritte (ii) bis (iv) automatisiert durchgeführt werden.

Die erfindungsgemäßen Verfahren gemäß dem ersten oder dem zweiten Aspekt der vorliegenden Erfindung können auch in Kombination durchgeführt werden. Dafür können zunächst die Messung des Höhenprofils im Schritt (i) und die Festlegung des radialen Abschnittes im Schritt (ii) für beide Verfahren gemeinsam und anschließend jeweils die Schritte (iii) bis (iv) für die Ermittlung der beiden Kennzahlen durchgeführt werden.

### Beschreibung eines erfindungsgemäßen Ausführungsbeispiels

Mittels Lichtschnittverfahren wurde das Profil des Randbereiches und des daran angrenzenden Bereichs einer polierten Scheibe aus einkristallinem Silizium mit einem Nenndurchmesser von 300 mm gemessen. Das gemessene Profil ist in Fig. 1 dargestellt. Die Messung erfolgte auf einem Messgerät zur Bestimmung des Kantenprofils des Herstellers Kobelco. Es wurden insgesamt 12200 Datenpunkte über einen radialen Bereich mit einer radialen Ausdehnung von 3 mm aufgenommen. Die Dichte der Messpukte nahm über den Messbereich in Radialinwärtsrichtung graduell ab. So wurden am äußeren Scheibenrand etwa 50 Messpunkte pro Mikrometer aufgenommen, während am zur Scheibenmitte hin zugewandten Ende des Messbereichs nur noch etwa 2 Messpunkte pro Mikrometer aufgenommen wurden.

Das gemessene Profil der Scheibe ist als x-y-Kurve in Fig. 2 dargestellt, wobei die x-Achse die radiale Position und die y-Achse die axiale Position angibt.

Die Auswertung der Messpunkte, die in Form eines x-y-Datensatzes als csv-Datei elektronisch gespeichert werden können, erfolgt vorzugsweise mit einer Software, beispielsweise Python oder Java. Die csv-Datei wird in diese Software eingelesen und mithilfe dieser entsprechend den erfindungsgemäßen Verfahren Kennzahlen für die Rundung gemäß dem ersten und dem zweiten Aspekt der vorliegenden Erfindung automatisch bestimmt. Die folgenden Schritte werden dabei ausgehend von der csv-Datei durchgeführt. Es erfolgte zunächst das Festlegen eines radialen Abschnittes, der einen Teil des gemessenen Randbereiches und einen Teil des gemessenen, in Radialinwärtsrichtung an den Randbereich angrenzenden Bereiches der Scheibe enthält. Der ausgewählte Abschnitt hatte dabei eine radiale Ausdehnung von 200 µm und wurde so ausgewählt, dass der für die Auswertung herangezogenen Teil des Randbereiches nicht mehr als 30% des Randbereichs, also der Facettenlänge, umfasst. Anschließend wurde im ausgewählten radialen Abschnitt jedem Messpunkt ein Winkel und ein Radius zugeordnet. Zur Bestimmung des Winkels θ und des Radius r eines bestimmten Messpunktes wurden dabei zwei benachbarte Messpunkte im Abstand a von 40 µm zum jeweiligen bestimmten Messpunkt herangezogen. Zunächst wurde der Winkel ϕ durch die drei Messpunkte definiert, wobei der mittlere Messpunkt den Winkelscheitel darstellte. Dann wurde der Winkel θ aus der Differenz 180°-ϕ erhalten und dem mittleren Messpunkt zugeordnet. Zur Bestimmung des Radius wurde zunächst ein Kreis identifiziert, auf dessen Kreislinie die jeweils drei Messpunkte lagen und anschließend der Radius des Kreises bestimmt. So wurde jedem Messpunkt im ausgewählten radialen Abschnitt ein Winkel θ und ein Radius r zugeordnet. Der größte Winkel θ und der kleinste Radius r im festgelegten radialen Abschnitt wurden anschließend identifiziert und als Kennzahlen für die Rundung herangezogen. Der größte Winkel θ im radialen Abschnitt betrug 13,9° und der kleineste Radius r im radialen Abschnitt betrug 172,4 µm.

## Patentansprüche

1. Verfahren zur Bestimmung der Rundung einer Scheibe aus Halbleitermaterial, umfassend die folgenden Schritte in dieser Reihenfolge:
(i) Messen des Höhenprofils einer Scheibe aus Halbleitermaterial in radialer Richtung in deren Randbereich und in einem in Radialinwärtsrichtung an den Randbereich angrenzenden Bereich, wobei der Randbereich definiert ist, als ringförmiger Bereich am äußeren Rand der Scheibe, in dem sich die Dicke der Scheibe in Radialauswärtsrichtung kontinuierlich verringert;
(ii) Festlegen eines radialen Abschnittes, der einen Teil des Randbereiches und zumindest einen Teil des in Radialinwärtsrichtung an den Randbereich angrenzenden Bereiches der Scheibe aus Halbleitermaterial umfasst;
(iii) Bestimmung eines Winkels ϕ und optional eines Winkels θ für bestimmte Messpunkte P1 des Höhenprofils im radialen Abschnitt,
wobei der Winkel ϕ aus dem jeweiligen bestimmten Messpunkt P1 als Scheitelpunkt, und zwei weiteren Messpunkten P2 und P3 des Höhenprofils gebildet wird, die in einem bestimmten radialen Abstand a vom Scheitelpunkt in Radialinwärtsrichtung und in Radialauswärtsrichtung angeordnet sind, und
wobei der Winkel θ aus der Differenz 180°-ϕ erhalten wird; und
(iv) Identifizieren des kleinsten Winkels ϕ oder optional des größten Winkles θ im radialen Abschnitt als Kennzahl für die Rundung.

2. Verfahren zur Bestimmung der Rundung einer Scheibe aus Halbleitermaterial, umfassend die folgenden Schritte in dieser Reihenfolge:
(i) Messen des Höhenprofils einer Scheibe aus Halbleitermaterial in radialer Richtung in deren Randbereich und in einem in Radialinwärtsrichtung an den Randbereich angrenzenden Bereich, wobei der Randbereich definiert ist, als ringförmiger Bereich am äußeren Rand der Scheibe, in dem sich die Dicke der Scheibe in Radialauswärtsrichtung kontinuierlich verringert;
(ii) Festlegen eines radialen Abschnittes, der einen Teil des Randbereiches und zumindest einen Teil des in Radialinwärtsrichtung angrenzenden Bereiches der Scheibe aus Halbleitermaterial umfasst;
(iii) Zuordnen eines Radius r zu bestimmten Messpunkten P1 des Höhenprofils im radialen Abschnitt, wobei der Radius r dem Radius eines Kreises entspricht, auf dessen Kreislinie der jeweilige bestimmte Messpunkt P1 und zwei weitere Messpunkte P2 und P3 des Höhenprofils liegen, die in einem bestimmten radialen Abstand a vom jeweiligen bestimmten Messpunkt in Radialinwärtsrichtung und in Radialauswärtsrichtung angeordnet sind; und
(iv) Identifizieren des kleinsten Radius r im radialen Abschnitt als Kennzahl für die Rundung.

3. Verfahren zur Bestimmung der Rundung einer Scheibe aus Halbleitermaterial gemäß dem Anspruch 1 oder 2, **dadurch gekennzeichnet, dass** der vom radialen Abschnitt umfasste Teil des Randbereiches und der vom radialen Abschnitt umfasste Teil des in Radialinwärtsrichtung angrenzenden Bereiches unabhängig voneinander jeweils mindestens 5 Messpunkte umfassen.

4. Verfahren zur Bestimmung der Rundung einer Scheibe aus Halbleitermaterial gemäß einem der Ansprüche 1 bis 3, **dadurch gekennzeichnet, dass** der radiale Abschnitt eine radiale Ausdehnung von nicht weniger als 100 µm aufweist.

5. Verfahren zur Bestimmung der Rundung einer Scheibe aus Halbleitermaterial gemäß dem Anspruch 4, **dadurch gekennzeichnet, dass** der radiale Abschnitt eine radiale Ausdehnung von nicht weniger als 200 µm und nicht mehr als 500 µm aufweist.

6. Verfahren zur Bestimmung der Rundung einer Scheibe aus Halbleitermaterial gemäß einem der Ansprüche 1 bis 5, **dadurch gekennzeichnet, dass** jeder der beiden Teile des radialen Abschnittes eine radiale Ausdehnung von nicht weniger als 50 µm hat.

7. Verfahren zur Bestimmung der Rundung einer Scheibe aus Halbleitermaterial gemäß einem der Ansprüche 1 bis 6, **dadurch gekennzeichnet, dass** der Teil des Randbereiches, der vom radialen Abschnitt umfasst wird, vorzugsweise eine radiale Ausdehnung von nicht mehr als 30%, besonders bevorzugt nicht mehr als 20%, der radialen Ausdehnung des gesamten Randbereiches der Scheibe aus Halbleitermaterial aufweist.

8. Verfahren zur Bestimmung der Rundung einer Scheibe aus Halbleitermaterial gemäß einem der Ansprüche 1 bis 7, **dadurch gekennzeichnet, dass** der bestimmte radiale Abstand a nicht weniger als 10 µm und nicht mehr 100 µm, vorzugsweise nicht weniger als 20 und nicht mehr als 80 µm, besonders bevorzugt nicht weniger als 30 µm und nicht mehr als 60 µm beträgt.

9. Verfahren zur Bestimmung der Rundung einer Scheibe aus Halbleitermaterial gemäß einem der Ansprüche 1 bis 8, **dadurch gekennzeichnet, dass** das Höhenprofil der Vorderseite der Scheibe gemessen wird.

10. Verfahren zur Bestimmung der Rundung einer Scheibe aus Halbleitermaterial gemäß einem der Ansprüche 1 bis 9, **dadurch gekennzeichnet, dass** die Messung des Höhenprofils im Schritt (i) mittels eines Lichtschnittverfahrens oder einer Reflektionsmessung erfolgt.

11. Verfahren zur Bestimmung der Rundung einer Scheibe aus Halbleitermaterial gemäß einem der Ansprüche 1 bis 10, **dadurch gekennzeichnet, dass** die Schritte (ii) bis (iv) mithilfe einer Software automatisch durchgeführt werden.
